(19) Europäisches Patentamt
European Patent Office
Office européen des brevets

(11) EP 2 118 953 B1

(12) FASCICULE DE BREVET EUROPEEN

(45) Date de publication et mention de la délivrance du brevet:
**22.12.2010 Bulletin 2010/51**

(51) Int Cl.:
*H01M 10/42* (2006.01)  *H01M 10/48* (2006.01)
*G01R 31/36* (2006.01)

(21) Numéro de dépôt: **08762101.7**

(22) Date de dépôt: **15.02.2008**

(86) Numéro de dépôt international:
**PCT/FR2008/050253**

(87) Numéro de publication internationale:
**WO 2008/104721 (04.09.2008 Gazette 2008/36)**

(54) **PROCEDE DE DIAGNOSTIC D'UNE BATTERIE PLOMB-ACIDE D'UN VEHICULE AUTOMOBILE ET SYSTEME POUR SA MISE EN OEUVRE**

VERFAHREN ZUR DIAGNOSTIZIERUNG DER BLEIBATTERIE EINES AUTOMOBILS UND SYSTEM ZUR DURCHFÜHRUNG DIESES VERFAHRENS

METHOD FOR DIAGNOSING THE LEAD-ACID BATTERY OF AN AUTOMOBILE AND SYSTEM FOR IMPLEMENTING THE SAME

(84) Etats contractants désignés:
**AT BE BG CH CY CZ DE DK EE ES FI FR GB GR HR HU IE IS IT LI LT LU LV MC MT NL NO PL PT RO SE SI SK TR**

(30) Priorité: **16.02.2007 FR 0753298**

(43) Date de publication de la demande:
**18.11.2009 Bulletin 2009/47**

(73) Titulaire: **Electricfil Automotive**
**01708 Miribel Cedex (FR)**

(72) Inventeurs:
• **ANDRIEU, Olivier**
  **F-01700 Beynost (FR)**

• **ACHILLE, Laurence**
  **F-69007 Lyon (FR)**

(74) Mandataire: **Thibault, Jean-Marc et al**
**Cabinet Beau de Loménie**
**51, Avenue Jean Jaurès**
**B.P. 7073**
**69301 Lyon Cédex 07 (FR)**

(56) Documents cités:
| | |
|---|---|
| **EP-A- 1 933 158** | **WO-A-01/51947** |
| **WO-A-02/097456** | **WO-A-03/071617** |
| **WO-A-2006/054066** | **WO-A-2007/105595** |
| **US-A1- 2003 025 481** | **US-A1- 2005 057 255** |

**Description**

La présente invention concerne le domaine technique des batteries de démarrage de type plomb-acide.

L'objet de invention trouve une application particulièrement avantageuse mais non exclusive pour une batterie de démarrage d'un véhicule automobile.

Une des causes majeures d'immobilisation d'un véhicule automobile est le dysfonctionnement de la batterie de démarrage. Il apparaît ainsi le besoin de connaître l'état de fonctionnement de la batterie afin de pouvoir prévenir l'utilisateur de la défaillance de la batterie.

Dans l'état de la technique, il est connu ainsi de déterminer l'état de vieillissement ou de santé d'une batterie à partir de l'évaluation de la résistance interne d'une batterie qui est déterminée lors de l'application d'un signal électrique alternatif aux bornes de la batterie. Un tel principe peut difficilement être mis en oeuvre pour une batterie embarquée dans un véhicule automobile.

Pour une batterie embarquée d'un véhicule automobile, il est connu de mesurer en permanence, les caractéristiques de la batterie, telles que la tension, le courant et la température afin d'en déduire son état de charge. En fonction de l'historique de l'état de charge, il peut être déduit l'état de fonctionnement de la batterie. En pratique, cette méthode s'avère relativement complexe et onéreuse à mettre en oeuvre.

Par ailleurs, il est connu par le document US 2003/025481 un système de gestion de l'énergie d'une batterie automobile permettant de déterminer l'état de charge et l'état de santé de la batterie à partir de mesures de tensions de courants et de températures réalisées lors d'une phase de fonctionnement forcée de la batterie. Un tel système s'avère relativement difficile et onéreux à mettre en oeuvre puisqu'un tel système doit être pourvu d'un module de contrôle pour placer la batterie dans une phase de fonctionnement forcée.

L'objet de l'invention vise donc à remédier aux inconvénients des solutions techniques connues en proposant un nouveau procédé pour établir de manière sûre, simple et peu coûteuse et en utilisant directement des points de fonctionnement normal de véhicule et donc sans sollicitation particulière de la batterie, le diagnostic d'une batterie plomb-acide équipant un véhicule automobile.

Pour atteindre un tel objectif, le procédé selon l'invention comporte les étapes suivantes :

- dans une phase d'expérimentation, à réaliser un paramétrage de l'état de santé d'une batterie plomb-acide pour différentes valeurs de l'état de charge de la batterie, pour chacune des valeurs de l'état de charge sont données les valeurs représentative de l'état de santé de la batterie pour des couples de valeurs de la température de la batterie et d'au moins un paramètre de la batterie qui est déterminé à partir de la tension et du courant de la batterie, la température, le courant et la tension étant mesurés pendant la phase de démarrage du véhicule, pour une plage de variation donnée de courant et en dehors de la première décharge,
- dans une phase de diagnostic de la batterie équipant le véhicule :

  - à mesurer lors de la phase de démarrage du véhicule, la température de la batterie et, en dehors de la première décharge, et dans une plage de variation de courant donnée, la tension et le courant correspondant pour en déduire après traitement, une valeur du paramètre de la batterie,
  - à déterminer l'état de charge de la batterie,
  - et à déterminer la valeur représentative de l'état de santé à l'aide du paramétrage et du couple des valeurs de la température mesurée et du paramètre déduit des mesures et pour l'état de charge, de manière à établir un diagnostic de la batterie.

A titre d'exemple, les valeurs représentatives de l'état de santé correspondent à des valeurs de la capacité en Ah de la batterie ou à des caractéristiques chimiques de la batterie.

A titre d'exemple également, le paramètre de la batterie est déterminé à partir des caractéristiques de la batterie telles que la tension et le courant délivrés par la batterie et leurs évolutions au cours du temps.

Selon une caractéristique préférée de réalisation, le paramètre de la batterie est déterminé à partir des caractéristiques de la batterie telles qu'une valeur de tension ou de courant considérée pour une valeur de seuil respectivement de courant et de tension, un ratio entre les valeurs pics de la tension et du courant, une valeur de courant ou de tension correspondant respectivement à une valeur pic de tension ou de courant, ou à l'évolution au cours du temps de la tension et du courant.

Selon une caractéristique préférée de réalisation, on distingue pour le calcul de l'état de santé, la capacité nominale $Q_n$ définie comme étant la capacité à l'état neuf de la batterie et la capacité réelle $Q_r$ qui prend en compte le vieillissement :

$$Q_r(Ah) = (1-\% \text{ vieillissement}) * Q_n(Ah)$$

Selon une caractéristique préférée de l'invention, le paramètre dynamique lié à la capacité nominale est calculé à partir des caractéristiques courant tension à fort courant et celui lié au taux de vieillissement est calculé à partir des caractéristiques courant tension à faible courant.

Selon une autre caractéristique de l'invention, la capacité nominale peut constituer une donnée d'entrée pour le système (calibration préalable) permettant ainsi de calculer la capacité réelle en estimant le vieillissement.

Selon une variante préférée de réalisation, le procédé consiste à déterminer l'état de charge de la batterie à partir de mesure des caractéristiques de la batterie réalisées pendant l'arrêt du véhicule, et de matrices donnant le pourcentage d'état de charge en fonction des couples de valeurs de la tension et de la température.

Avantageusement, le procédé consiste à réaliser les mesures après un temps d'arrêt du véhicule nécessaire à la stabilisation physico-chimique de la batterie.

Un autre objet de l'invention est de proposer un procédé permettant d'établir un diagnostic sur l'aptitude au démarrage d'une batterie plomb-acide d'un véhicule automobile.

Pour atteindre un tel objectif, le procédé selon l'invention consiste à établir l'aptitude au démarrage de la batterie en fonction de la valeur représentative de l'état de santé.

Selon une première variante de réalisation, le procédé consiste à établir l'aptitude au démarrage de la batterie en enregistrant les évolutions de la valeur représentative de l'état de santé déterminée lors de la répétition de la phase de fonctionnement de la batterie et en fournissant une information sur l'aptitude au démarrage de la batterie lorsque la valeur représentative de l'état de santé atteint une valeur de seuil déterminée ou lorsque l'évolution dépasse une plage de variation déterminée.

Selon une caractéristique de l'invention, on peut distinguer deux évaluations différentes de l'aptitude au démarrage, une évaluation au cycle de fonctionnement actuel et une évaluation prédictive qui dépend de l'évolution de l'état de charge et de la température.

Selon cet exemple, le procédé consiste à établir l'aptitude au démarrage de la batterie en déterminant un indice de démarrage, en fonction de l'état de santé de la batterie, pour la valeur du paramètre et à la température mesurée.

Selon une autre variante de réalisation, le procédé consiste

- pour la valeur représentative de l'état de santé, à déduire à l'aide du paramétrage, une valeur du paramètre pour la valeur de la température mesurée affectée d'un coefficient de sécurité et de l'état de charge déterminé affecté d'un coefficient de sécurité,
- et à établir de manière prédictive l'aptitude au démarrage de la batterie en fonction de la valeur du paramètre de la batterie et de l'évolution des conditions de fonctionnement de la batterie.

Selon cet exemple, le procédé consiste à calculer l'indice de démarrage, à plusieurs reprises lors de la phase de fonctionnement de la batterie, et à examiner l'évolution de cet indice pour fournir un diagnostic sur l'aptitude au démarrage de la batterie.

Avantageusement, le procédé consiste en fonction de l'indice de démarrage à fournir une information soit de démarrage sans problème, soit de démarrage difficile, ou soit de démarrage impossible.

De préférence, le procédé consiste pour un indice de démarrage difficile, à fournir une information de préconisation de chauffage, de chargement ou de changement de la batterie.

Par exemple, le procédé consiste pour un indice de démarrage difficile, à préconiser :

- de charger la batterie si l'état de charge est faible,
- de changer la batterie si l'état de charge est important.

Un autre objet de l'invention est de proposer un système pour la mise en oeuvre du procédé de diagnostic conforme à l'invention.

Pour atteindre un tel objectif, le système comporte dans un boîtier équipé de moyens de montage :

- un capteur de mesure du courant délivré par la batterie,
- un capteur de mesure de la tension de la batterie,
- un capteur de mesure de la température de la batterie,
- une unité d'acquisition et de traitement reliée aux capteurs de mesure et comportant :

    . des moyens de mémorisation d'un paramétrage de l'état de santé d'une batterie plomb-acide pour différentes valeurs de l'état de charge de la batterie, pour chacune des valeurs de l'état de charge sont données les valeurs représentatives de l'état de santé de la batterie pour des couples de valeurs de la température de la batterie et d'un paramètre de la batterie qui est déterminé à partir des mesures de tension et du courant réalisées dans une plage de variation donnée de courant, en dehors de la première décharge et lors de la phase de démarrage du véhicule,

. des moyens pour déterminer l'état de charge de la batterie,

. des moyens pour déterminer la valeur représentative de l'état de santé de la batterie à l'aide du paramétrage et du couple des valeurs de la température mesurée et du paramètre déduit des mesures et pour l'état de charge déterminé,

. et des moyens de fourniture d'une information sur la valeur représentative de l'état de santé de la batterie.

Par exemple, l'unité d'acquisition et de traitement comporte des moyens pour établir l'aptitude au démarrage de la batterie en fonction de la valeur représentative de l'état de santé et en ce que les moyens d'information donnent une information sur l'aptitude au démarrage de la batterie.

Avantageusement, le capteur de mesure du courant délivré par la batterie est du type sans contact.

Par exemple, le capteur de mesure de la température de la batterie est monté à l'intérieur ou à l'extérieur du boîtier.

Diverses autres caractéristiques ressortent de la description faite ci-dessous en référence aux dessins annexés qui montrent, à titre d'exemples non limitatifs, des formes de réalisation de l'objet de l'invention.

La **Figure 1** est un schéma illustrant un système de diagnostic pour une batterie conforme à l'invention.

La **Figure 2** est un schéma fonctionnel du système de diagnostic conforme à l'invention.

La **Figure 2A** est un exemple de courbes de courant et de tension en fonction du temps, délivrés par une batterie lors de la phase de démarrage d'un véhicule.

La **Figure 3** est une représentation tridimensionnelle explicitant le principe de paramétrage conforme à l'invention.

La **Figure 4** illustre l'évolution d'une valeur représentative de l'état de santé d'une batterie en fonction de démarrages successifs.

La **Figure 5** illustre l'utilisation des caractéristiques mesurées de la batterie pour estimer son aptitude au démarrage au cycle de fonctionnement actuel et prédire son aptitude au démarrage dans un état ultérieur.

La **Figure 6** présente un moyen de détection des différentes phases de fonctionnement du véhicule en utilisant la mesure de courant et de tension.

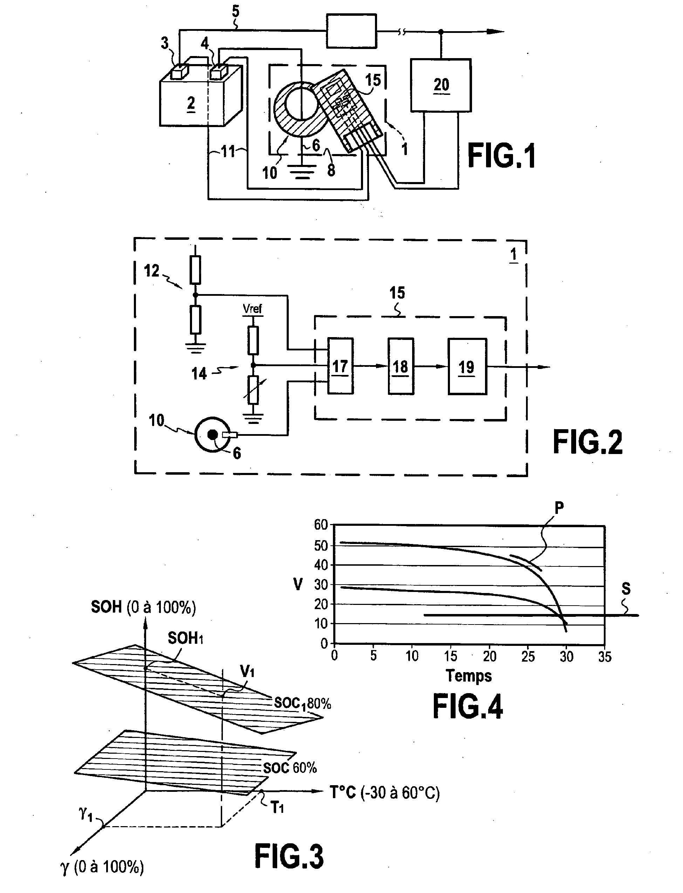

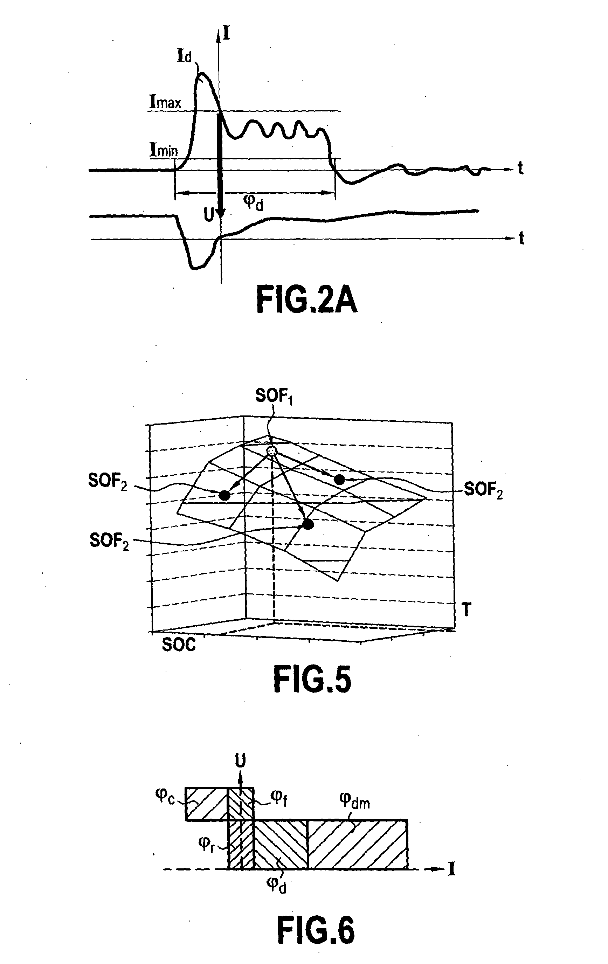

Tel que cela ressort des **Fig. 1** et **2,** l'objet de l'invention concerne un système **1** permettant d'établir un diagnostic sur une batterie **2** du type plomb-acide équipant un véhicule automobile au sens général.

D'une manière classique, une batterie **2** comporte des bornes positive **3** et négative **4** sur lesquelles sont raccordés des câbles respectivement de liaison **5** et de massé **6.**

Le système **1** se présente sous la forme d'un boîtier **8** équipé de moyens de montage non représenté permettant sa fixation de préférence sur les câbles de la batterie. Le système **1** comporte un capteur **10** de mesure du courant **I** délivré par la batterie **2**. Selon un exemple préféré de réalisation, le capteur de mesure **10** est un capteur magnétique du type sans contact monté autour du câble de masse **6**. Par exemple, le capteur de mesure **10** de courant est du type résistif ou du type à champ magnétique tel un capteur à effet hall, magnéto-résistance, GMR ou flux gate.

Le système **1** est relié aux bornes **3** et **4** par des câbles **11** et comporte un capteur **12** de mesure de la tension **U** délivrée par la batterie **2**. Bien entendu, la tension **U** délivrée par la batterie **2** peut être mesurée à un endroit différent des bornes **3, 4**. Le système **1** comporte également un capteur **14** de mesure de la température **T** de la batterie **2**. De préférence, le capteur **14** de mesure de la température est monté à l'intérieur du boîtier **8** permettant de rendre le capteur moins sensible aux variations de température extérieure. Bien entendu, le capteur de température **14** peut être monté à l'extérieur du boîtier **8**.

Tel que cela ressort plus précisément de la **Fig. 2,** le système **1** comporte une unité **15** d'acquisition et de traitement reliée au capteur de mesure de courant **11**, de tension **12** et de température **14**. Cette unité **15** comporte en entrée un multiplexeur **17** dont l'entrée est reliée aux capteurs de mesure **11, 12** et **14** et en sortie, à un convertisseur analogique numérique **18** connecté en sortie à un circuit numérique de traitement **19** architecturé autour d'un microprocesseur associé de manière classique notamment à des mémoires et à une horloge. Le circuit numérique de traitement **19** comporte des moyens algorithmiques permettant la mise en oeuvre d'un procédé visant à établir un diagnostic sur la batterie **2**. Avantageusement, cette unité **15** comporte des moyens de fourniture d'une information sur le diagnostic de la batterie, à une unité **20** de gestion centrale associée au véhicule.

Il doit être considéré que le procédé selon l'invention comporte une phase d'expérimentation qui précède la phase proprement dite de diagnostic d'une batterie **2** d'un véhicule équipée d'un système **1** tel que décrit ci-dessus. Conformément à l'invention, la phase d'expérimentation et la phase de diagnostic sont réalisées pour la même phase de fonctionnement de la batterie. Il est à noter qu'une batterie comporte plusieurs phases de fonctionnement, à savoir, une phase de charge φc, une phase de décharge φd, une phase de démarrage φdm et une phase de « floating » φf c'est-à-dire une phase où la batterie est maintenue chargée dans un circuit électrique. Conformément à l'invention, la phase de diagnostic et la phase d'expérimentation sont réalisées pour la phase de démarrage φdm du véhicule.

Dans la phase d'expérimentation, le procédé consiste à réaliser un paramétrage de l'état de santé **SOH** d'une batterie plomb-acide dite d'expérimentation pour différentes valeurs de l'état de charge **SOC** de la batterie. Par exemple, cette phase d'expérimentation utilise une batterie présentant la même capacité nominale que celle de la batterie **2** à diagnostiquer.

Pour mémoire, l'état de santé appelé également **SOH** d'une batterie, reflète le vieillissement de la batterie. L'état de santé **SOH** d'une batterie est caractérisé par des valeurs représentatives correspondant par exemple à des valeurs de la capacité en Ah de la batterie ou à des caractéristiques chimiques de la batterie.

Selon une caractéristique préférée de réalisation, on distingue pour le calcul de l'état de santé, la capacité nominale $Q_n$ définie comme étant la capacité à l'état neuf de la batterie et la capacité réelle $Q_r$ qui prend en compte le vieillissement :

$$Q_r (Ah)= (1-\% \text{ vieillissement})* Q_n(Ah)$$

Ce paramétrage de l'état de santé **SOH** est réalisé pour différentes valeurs de l'état de charge appelées également **SOC** de la batterie d'expérimentation. Pour mémoire, l'état de charge **SOC** d'une batterie correspond à un pourcentage de la capacité réelle de la batterie.

Pour chacune des valeurs de l'état de charge **SOC,** il est déterminé des valeurs représentatives de l'état de santé de la batterie pour des couples de valeurs de la température **T** de la batterie et d'au moins un paramètre γ de la batterie. Le paramètre γ est déterminé à partir des caractéristiques de la batterie.

Conformément à l'objet de l'invention, le paramètre γ est déterminé à partir des mesures effectuées lors de la phase de démarrage du véhicule. Tel que cela ressort plus précisément de la **Fig. 2A,** pendant la phase de démarrage φdm, et en, dehors de la première décharge **ID,** la température, le courant **I** et la tension **U** sont mesurés. Il est à noter que le courant **I** et la tension **U** sont mesurés dans une plage de variation de courant donné, c'est-à-dire entre une valeur maximale $I_{max}$ et une valeur minimale $I_{min}$ de courant. En dehors de ces valeurs $I_{max}$ et $I_{min}$, les valeurs de courant et de tension ne sont pas prises en compte. Tel est le cas pour la valeur de décharge **Id** qui correspond au premier pic de courant dû à la décharge capacitive de la batterie. Tel est le cas également pour la valeur du coursant proche de la valeur nulle.

Après traitement, de telles mesures permettent de déduire une valeur du paramètre γ de la batterie.

Le paramètre γ correspond par exemple :

- à une valeur de courant considérée pour une valeur de seuil de la tension,
- à une valeur de tension considérée pour une valeur de seuil de courant,
- à une valeur de tension correspondant à une valeur pic de courant,
- à une valeur de courant correspondant à une valeur pic de tension,
- au ratio entre une variation de la tension ΔU et une variation de courant ΔI,
- à un ratio entre les valeurs pics de la tension **U** et du courant **I**,
- à l'évolution au cours du temps de la tension **U** et du courant **I.**

Dans un exemple particulier de réalisation, l'état de santé SOH est défini à l'aide de deux paramètres dynamiques γ, un à fort courant en début de décharge pour estimer la capacité nominale de la batterie et un à faible courant en fin de décharge pour estimer le vieillissement.

La phase d'expérimentation consiste donc à établir des tableaux ou des matrices de correspondance donnant des valeurs caractéristiques de l'état de santé **SOH** de la batterie, pour différentes valeurs de l'état de charge **SOC** et pour des couples de valeurs de la température T et du paramètre γ. La **Fig. 3** illustre sous la forme d'une représentation graphique tridimensionnelle le paramétrage de l'état de santé **SOH** d'une batterie, en fonction de la température **T** et du paramètre γ, pour différentes valeurs de l'état de charge **SOC.** Par exemple, la température varie de (-30°C à 60°C) tandis que l'état de charge **SOC,** l'état de santé **SOH** et le paramètre γ varient dans une plage de 0 à 100 %. De préférence, le paramétrage est effectué en choisissant de façon appropriée des valeurs discrètes qui sont ensuite interpolées pour disposer d'une variation continue des valeurs. Dans l'exemple illustré, l'état de santé **SOH** a été représenté pour deux valeurs de l'état de charge **SOC** (à savoir 60 % et 80 %) mais il est clair que l'état de santé **SOH** peut être défini pour un nombre supérieur de valeurs d'états de charge **SOC.** Ainsi, la valeur caractéristique $V_1$ de l'état de santé $SOH_1$ est donc définie par une valeur $SOC_1$ de l'état de charge et pour une température $T_1$ et pour une valeur $γ_1$

du paramètre.

Le paramétrage ainsi réalisé est avantageusement mémorisé dans le système de diagnostic **1** destiné à équiper une batterie **2** devant être surveillée.

Le système **1** selon l'invention est adapté pour mettre en oeuvre une phase de diagnostic pour laquelle la batterie **2** est à surveiller afin de permettre d'établir un diagnostic de la batterie **2.**

Le système **1** détermine de manière répétée l'état de charge **SOC** de la batterie. L'état de charge **SOC** de la batterie peut être déterminé de toute manière connue.

Selon une caractéristique préférée de l'invention, l'état de charge **SOC** de la batterie est déterminé à partir de mesures réalisées pendant l'arrêt du véhicule, c'est-à-dire à courant **I** nul et à partir de matrices donnant le pourcentage d'état de charge **SOC** en fonction des couples de valeurs de la tension **U** et de température **T.**

Lors de la phase de diagnostic, l'état de charge **SOC** de la batterie est déterminé lorsque le courant est nul. De préférence, les mesures de la tension **U** et de la température **T** sont réalisées après un temps d'arrêt du véhicule nécessaire à la stabilisation physico-chimique de la batterie.

Dans la phase de diagnostic, le procédé selon l'invention mesure à plusieurs reprises, la température et au moins le courant et la tension de la batterie et traite les valeurs mesurées. Comme expliqué en relation de la **Fig. 2A,** les mesures de température, courant et tension de la batterie sont enregistrées pour une phase de fonctionnement de la batterie qui correspond à la phase de démarrage du véhicule. Les mesures sont réalisées comme expliqué ci-avant c'est-à-dire que le courant **I** et la tension **U** sont mesurés dans la plage de variation de courant $I_{max}$-$I_{min}$, en excluant la première décharge du courant **Id.** Ces mesures des caractéristiques de la batterie sont ensuite traitées pour déterminer la valeur du paramètre γ.

Le procédé consiste ensuite à l'aide du paramétrage et à partir de cette valeur du paramètre γ et de la température mesurée, pour la valeur déterminée de l'état de charge **SOC,** à déterminer la valeur représentative de l'état de santé de la batterie **2.** Selon une variante de réalisation, le procédé consiste à déterminer l'état de santé de la batterie en prenant en compte la capacité nominale de la batterie qui est calculé à partir des caractéristiques courant-tension prises pour des valeurs élevées de courant tandis que le taux de vieillissement est calculé pour des caractéristiques courant-tension prises pour des valeurs faibles de courant. Dans l'exemple illustré à la **Fig. 2A,** les mesures effectuées dans la plage proche de la valeur $I_{max}$ sont représentatives de la capacité nominale tandis que les mesures effectuées dans la plage proche de la valeur $I_{min}$ sont représentatives du vieillissement.

Selon une autre variante de réalisation, le procédé consiste à comparer la capacité nominale de la batterie à une valeur de préconisation de manière à délivrer un signal d'alerte lorsque la batterie présente une capacité nominale inférieure à la valeur de préconisation. Cette valeur de préconisation fournit par le fabricant du véhicule permet d'alerter l'utilisateur du véhicule d'un montage d'une batterie inappropriée pour le véhicule.

Cette valeur représentative de l'état de santé permet d'effectuer un diagnostic de la batterie. Ce diagnostic permet d'évaluer les capacités de fonctionnement de la batterie. Il est à noter que le procédé de diagnostic conforme à l'invention est réalisé en utilisant uniquement des caractéristiques de fonctionnement normal de la batterie équipant un véhicule. En particulier, les mesures de courant **I** et de tension **U** correspondent directement aux valeurs délivrées par la batterie qui n'est pas raccordée à une source de sollicitation supplémentaire.

Selon une caractéristique préférée, ce diagnostic qui donne la valeur représentative de l'état de santé de la batterie permet d'établir l'aptitude au démarrage de la batterie.

Le procédé selon l'invention a ainsi pour objectif, après avoir déterminé l'état de fonctionnement de la batterie, de fournir une information sur la capacité ou l'aptitude de la batterie à permettre le démarrage du véhicule. Ce diagnostic prédictif permet ainsi d'avertir l'utilisateur du véhicule avant la défaillance de la batterie.

Selon un premier exemple de réalisation, l'aptitude au démarrage de la batterie est établie en enregistrant les évolutions de la valeur représentative de l'état de santé déterminé lors de la répétition ou de la succession de la phase de fonctionnement de la batterie. Le procédé consiste à fournir une information sur l'aptitude au démarrage en fonction de l'évolution de cette valeur représentative **V** de l'état de santé. Tel que cela ressort plus précisément de la **Fig. 4,** une telle information est fournie soit lorsque la valeur représentative de l'état de santé atteint une valeur de seuil **S** déterminée ou soit lorsque l'évolution dépasse une plage de variation **P** déterminée.

Selon un deuxième exemple de réalisation, l'aptitude au démarrage est établie à partir de la valeur du paramètre γ de la batterie. Ainsi, pour la valeur représentative de l'état de santé et à l'aide du paramétrage, il est déterminé une nouvelle valeur du paramètre γ pour la valeur de la température mesurée affectée d'un coefficient de sécurité et pour l'état de charge **SOC** déterminé affecté d'un coefficient de sécurité. En effet, il apparaît judicieux de prendre en compte une chute de température qui peut apparaître entre le moment où le véhicule est à l'arrêt et le prochain démarrage (chute de température nocturne). En d'autres termes, le paramètre γ est déduit pour la valeur de la température mesurée affectée d'un coefficient de sécurité. De même, dans le cas d'une décharge de la batterie, l'état de charge **SOC** déterminé est affecté d'un coefficient de sécurité. Ainsi, la valeur du paramètre γ est déduite, à l'aide du paramétrage et pour la valeur de la température mesurée affectée d'un coefficient de sécurité et de l'état de charge **SOC** déterminé affecté d'un coefficient de sécurité. En fonction de cette valeur du paramètre γ de la batterie, il peut être établi de manière prédictive l'aptitude au démarrage de la batterie. A titre d'exemple, il peut être prévu de décomposer la plage de variation du paramètre γ en plusieurs zones égales ou non, correspondant chacune à une qualification différente de l'aptitude au démarrage. A titre d'exemple, la plage de variation du paramètre γ est décomposée en trois zones correspondant aux valeurs faibles, moyennes et fortes du paramètre γ et pour lesquelles le démarrage est considéré respectivement, impossible, difficile et sans problème.

Ainsi tel que cela ressort de la **Fig. 5,** il peut être déterminé une aptitude au démarrage **SOF$_1$** correspondant au cycle de fonctionnement actuel de la batterie et une évaluation prédictive de l'aptitude au démarrage **SOF$_2$** qui dépend de l'évolution de l'état de charge **SOC** et de la température **T.** Ainsi dans l'exemple illustré à la **Fig. 5,** à partir de l'aptitude au démarrage **SOF$_1$,** il peut être déterminé une aptitude au démarrage **SOF$_2$** avec une diminution du **SOC,** une diminution de la température **T** et une diminution du **SOC** et de la température **T.**

Selon un autre exemple de réalisation, l'aptitude au démarrage de la batterie **2** est établie en déterminant un indice de démarrage **d** qui est fonction de l'état de santé de la batterie, pour la valeur du paramètre γ et à la température mesurée **T.**

Ces indices **d** sont surveillés afin d'en déduire un diagnostic sur l'aptitude de démarrage de la batterie. En d'autres termes, à plusieurs reprises lors de la phase de fonctionnement de la batterie, est calculé un indice de démarrage **d** et l'évolution de cet indice est examinée pour fournir un diagnostic sur l'aptitude au démarrage de la batterie.

L'indice peut être décomposé de manière à fournir de préférence une information soit de démarrage sans problème, soit de démarrage difficile ou soit de démarrage impossible.

Un autre objet de l'invention est de proposer une méthode de mesure des caractéristiques de la batterie selon les modes de fonctionnement de la batterie dans le véhicule.

Pour atteindre un tel objectif, ce procédé permet de détecter la phase de fonctionnement de la batterie. Tel que cela ressort plus précisément de la **Fig. 6,** à partir des mesures de courant **I** et de tension **U** de la batterie, il est possible de déterminer les diverses phases de fonctionnement de la batterie, à savoir : charge φ**c**, floating φ**f**, décharge φ**d**, repos φ**r** ou démarrage φ**dm**.

Selon une variante de l'invention, au cours de la charge et du floating, le procédé mesure l'état de charge par coulométrie (comptage des Ah) et calcule la température de la batterie à l'aide d'un modèle thermique.

Selon cette même variante, au cours de la phase de repos, le capteur mesure la tension à vide de la batterie et le procédé la relie à l'état de charge. La mise en veille du capteur est activée lors de cette phase et un réveil périodique est programmé pour le calcul de l'état de charge à l'aide de la tension à vide, pour le calcul de la température interne de la batterie, pour la prédiction de l'aptitude au démarrage SOF2. L'évolution de la tension est aussi calculée lors de cette phase. Le réveil du capteur lors de cette phase est effectuée après avoir détecté une variation de tension dépassant un seuil donné ou à l'aide d'un réseau LIN (Local Interconnect Network) du véhicule ou de tout autre réseau de communication.

Selon cette même variante de l'invention, au cours de la phase de décharge, le capteur est réveillé et l'algorithme calcul l'état de charge par coulométrie, calcul une aptitude au démarrage prédictive et réalise la mesure de la température interne.

Selon cette même variante de l'invention, au cours de la phase de démarrage du véhicule, le procédé calcule l'état de santé de la batterie, l'aptitude au démarrage au cycle de fonctionnement actuel SOF1, réalise le calcul de l'état de charge à l'aide de la coulométrie et la température interne de la batterie à l'aide du modèle thermique.

L'invention n'est pas limitée aux exemples décrits et représentés car diverses modifications peuvent y être apportées sans sortir de son cadre.

**Revendications**

1. Procédé de diagnostic d'une batterie plomb-acide (2) d'un véhicule automobile, **caractérisé en ce qu'**il comporte les étapes suivantes :

   • dans une phase d'expérimentation, à réaliser un paramétrage de l'état de santé **(SOH)** d'une batterie plomb-acide pour différentes valeurs de l'état de charge **(SOC)** de la batterie, pour chacune des valeurs de l'état de charge sont données les valeurs représentative de l'état de santé de la batterie pour des couples de valeurs de la température **(T)** de la batterie et d'au moins un paramètre (γ) de la batterie qui est déterminé à partir de la tension (U) et du courant (**I**) de la batterie, la température (**T**), le courant (**I**) et la tension (**U**) étant mesurés pendant la phase de démarrage du véhicule, pour une plage de variation donnée de courant et en dehors de la première décharge,
   • dans une phase de diagnostic de la batterie équipant le véhicule :

      - à mesurer lors de la phase de démarrage du véhicule, la température de la batterie et, en dehors de la première décharge, et dans une plage de variation de courant donnée, la tension (**U**) et le courant (**I**) correspondant pour en déduire après traitement, une valeur du paramètre ($\gamma$) de la batterie,
- à déterminer l'état de charge **(SOC)** de la batterie,
- et à déterminer la valeur représentatives de l'état de santé à l'aide du paramétrage et du couple des valeurs de la température mesurée et du paramètre ($\gamma$) déduit des mesurés et pour l'état de charge **(SOC),** de manière à établir un diagnostic de la batterie.

2. Procédé selon la revendication 1, **caractérisé en ce que** les valeurs représentatives de l'état de santé correspondent à des valeurs de la capacité en Ah de la batterie ou à des caractéristiques chimiques de la batterie.

3. Procédé selon la revendication 1, **caractérisé en ce que** le paramètre ($\gamma$) de la batterie est déterminé à partir des caractéristiques de la batterie telles qu'une valeur de tension ou de courant considérée pour une valeur de seuil respectivement de courant et de tension, un ratio entre les valeurs pics de la tension et du courant, une valeur de courant ou de tension correspondant respectivement à une valeur pic de tension ou de courant, ou à l'évolution au cours du temps de la tension et du courant.

4. Procédé selon l'une des revendications 1 à 3, **caractérisé en ce qu'**il consiste à déterminer l'état de santé **(SOH)** de la batterie en prenant en compte la capacité nominale **($Q_n$)** de la batterie qui est calculé à partir des caractéristiques courant-tension prises pour des valeurs élevées de courant tandis que le taux de vieillissement est calculé pour des caractéristiques courant-tension prises pour des valeurs faibles de courant.

5. Procédé selon l'une des revendications 1 à 4, **caractérisé en ce qu'**il consiste à comparer la capacité nominale de la batterie à une valeur de préconisation de manière à délivrer un signal d'alerte lorsque la batterie présente une capacité nominale inférieure à la valeur de préconisation.

6. Procédé selon la revendication 1, **caractérisé en ce qu'**il consiste à partir des mesures de courant et de tension, à déterminer les phases de fonctionnement de la batterie dans le véhicule à savoir, charge, floating, décharge, repos ou démarrage.

7. Procédé selon la revendication 1, **caractérisé en ce qu'**il consiste à déterminer l'état de charge **(SOC)** de la batterie à partir de mesures des caractéristiques de la batterie réalisées pendant l'arrêt du véhicule, et de matrices donnant le pourcentage d'état de charge **(SOC)** en fonction des couples de valeurs de, la tension (U) et de la température **(T).**

8. Procédé selon la revendication 7, **caractérisé en ce qu'**il consiste à réaliser les mesures après un temps d'arrêt du véhicule nécessaire à la stabilisation physico-chimique de la batterie.

9. Procédé selon la revendication 1 ou 2, **caractérisé en ce qu'**il consiste à établir l'aptitude au démarrage de la batterie en fonction de la valeur représentative de l'état de santé.

10. Procédé selon la revendication 9, **caractérisé en ce qu'**il consiste à établir l'aptitude au démarrage de la batterie en enregistrant les évolutions de la valeur représentative de l'état de santé déterminée lors de la répétition de la phase de fonctionnement de la batterie et en fournissant une information sur l'aptitude au démarrage de la batterie lorsque la valeur représentative de l'état de santé atteint une valeur de seuil déterminée ou lorsque l'évolution dépasse une plage de variation déterminée.

11. Procédé selon la revendication 9, **caractérisé en ce qu'**il consiste à établir l'aptitude au démarrage (**SOF$_1$**) de la batterie en déterminant un indice de démarrage **(d),** en fonction de l'état de santé de la batterie, pour la valeur du paramètre ($\gamma$) et à la température mesurée **(T).**

12. Procédé selon la revendication 1, **caractérisé en ce qu'**il consiste :

- pour la valeur représentative de l'état de santé, à déduire à l'aide du paramétrage, une valeur du paramètre ($\gamma$) pour la valeur de la température mesurée affectée d'un coefficient de sécurité et de l'état de charge (**SOC**) déterminé affecté d'un coefficient de sécurité,
- et à établir de manière prédictive l'aptitude au démarrage (**SOF$_2$**) de la batterie en fonction de la valeur du paramètre ($\gamma$) de la batterie et de l'évolution des conditions de fonctionnement de la batterie.

13. Procédé, selon la revendication 11, **caractérisé en ce qu'**il consiste à calculer l'indice de démarrage **(d),** à plusieurs reprises lors de la phase de fonctionnement de la batterie, et à examinér l'évolution de cet indice pour fournir un diagnostic sur l'aptitude au démarrage de la batterie.

14. Procédé selon la revendication 13, **caractérisé en ce qu'**il consiste en fonction de l'indice de démarrage à fournir une information soit de démarrage sans problème, soit de démarrage difficile, ou soit de démarrage impossible.

15. Procédé selon la revendication 14, **caractérisé en ce qu'**il consiste pour un indice de démarrage difficile, à fournir une information de préconisation de chauffage, de chargement ou de changement de la batterie.

16. Procédé selon la revendication 14 ou 15, **caractérisé en ce qu'**il consiste pour un indice de démarrage difficile, à préconiser :

- de charger la batterie si l'état de charge **(SOC)** est faible,
- de changer la batterie si l'état de charge **(SOC)** est important.

## Claims

1. Diagnosis method for a lead-acid battery (2) of an automotive vehicle, **characterized in that** it comprises the following steps:

   • during an experimentation phase, of conducting parameterization of the state of health (SOH) of a lead-acid battery for different values of the state of charge (SOC) of the battery, for each of the state of charge values there are values representing the state of health of the battery for pairs of values including battery temperature (T) and at least one battery parameter ($\gamma$) which is determined from battery voltage (U) and current (I), the temperature (T), current (I) and voltage (U) being measured during the vehicle start-up phase over a given range of current variation and after the first discharge,
   • during a diagnosis phase of the battery equipping the vehicle:

      - during the start-up phase of the vehicle, of measuring the temperature of the battery and, after the first discharge and over a given range of current variation, of measuring the corresponding voltage (U) and current (I) so as to deduce, after processing, a parameter value ($\gamma$) of the battery,
      - of determining the state of charge (SOC) of the battery, and
      - of determining the value representing the state of health of the battery using the parameterization and the pair of values of measured temperature and parameter ($\gamma$) deduced from measurements, for the state of charge (SOC), so as to establish a diagnosis of the battery.

2. Method according to claim 1, **characterized in that** the values representing the state of health correspond to values of the Ah capacity of the battery or to chemical characteristics of the battery.

3. Method according to claim 1, **characterized in that** the parameter ($\gamma$) of the battery is determined from characteristics of the battery such as a considered voltage or current value for a threshold value of current and voltage respectively, a ratio between the peak voltage and current values, a current or voltage value corresponding respectively to a peak voltage or peak current value or to changes over time in voltage and current.

4. Method according to any of claims 1 to 3, **characterized in that** it consists of determining the state of health (SOH) of the battery taking into account the nominal capacity (Qn) of the battery which is calculated from current-voltage characteristics at high current values, whilst the ageing rate is calculated from current-voltage values at low current values.

5. Method according to any of claims 1 to 4, **characterized in that** it consists of comparing the nominal capacity of the battery with a recommended value so as to deliver an alert signal when the battery shows a nominal capacity lower than the recommended value.

6. Method according to claim 1, **characterized in that**, on the basis of current and voltage measurements, it consists of determining the operating phases of the battery in the vehicle namely charge, floating, discharge, rest or start-up.

7. Method according to claim 1, **characterized in that** it consists of determining the state of charge (SOC) of the battery from measurements of battery characteristics taken during stoppage of the vehicle, and from matrices giving the percentage state of charge (SOC) in relation to pairs of voltage (U) and temperature (T) values.

8. Method according to claim 7, **characterized in that** it consists of taking the measurements after a period of vehicle stoppage required for physicochemical stabilization of the battery.

9. Method according to claim 1 or 2, **characterized in that** it consists of determining the start-up capability of the battery in relation to the value representing the state of health.

10. Method according to claim 9, **characterized in that** it consists of determining the start-up capability of the battery by recording changes in the value representing the state of health as determined during repetition of the operating phase of the battery, and giving information on start-up capability of the battery when the value representing the state of health reaches a determined threshold value or when changes exceed a determined range of variation.

11. Method according to claim 9, **characterized in that** it consists of establishing start-up capability ($SOF_1$) of the battery by determining a start-up index (d) in relation to the state of health of the battery, for the value of parameter ($\gamma$) and at the measured temperature (T).

12. Method according to claim 1, **characterized in that** it consists:

- for the value representing the state of health and by means of the parameterization, of deducing a value of parameter ($\gamma$) at the value of measured temperature to which a safety factor is applied and at the value of determined state of charge (SOC) to which a safety factor is applied; and
- of establishing predictive determination of the start-up capability ($SOF_2$) of the battery in relation to the value of battery parameter ($\gamma$) and changes in battery operating conditions.

13. Method according to claim 11, **characterized in that** it consists of calculating the start-up index (d) on several occasions during the battery operating phase, and of monitoring changes in this index to provide a diagnosis on the battery's start-up capability.

14. Method according to claim 13 **characterized in that**, in relation to the start-up index, it consists of providing information either on problem-free start-up, or on difficult start-up or on impossible start-up.

15. Method according to claim 14 **characterized in that**, for a difficult start-up index, it consists of providing information on recommended heating, charging or battery change.

16. Method according to claim 14 or claim 15 **characterized in that**, for a difficult start-up index, it consists of recommending:

- charging the battery if the state of charge (SOC) is low; and
- replacing the battery if the state of charge (SOC) is high.


**Patentansprüche**

1. Verfahren zur Diagnostizierung einer Bleibatterie (2) eines Automobils, **dadurch gekennzeichnet, daß** es die folgenden Schritte aufweist:

• in einer Experimentierphase, Durchführen einer Parametrierung des Alterungszustands (SOH) einer Bleibatterie für verschiedene Werte des Ladezustands (SOC) der Batterie; für jeden der Werte des Ladezustands werden die für den Alterungszustand der Batterie repräsentativen Werte für Wertepaare angegeben, die aus der Temperatur (T) der Batterie und mindestens einem Parameter ($\gamma$) der Batterie bestehen, welcher ausgehend von der Spannung (U) und der Stromstärke (I) der Batterie bestimmt wird, wobei die Temperatur (T), die Stromstärke (I) und die Spannung (U) während der Anlaßphase des Fahrzeugs für einen gegebenen Variationsbereich der Stromstärke und außerhalb des ersten Entladevorgangs gemessen werden,
• in einer Phase der Diagnostizierung der Batterie, mit der das Fahrzeug ausgerüstet ist:

- Messen, während der Anlaßphase des Fahrzeugs, der Temperatur der Batterie und, außerhalb des ersten Entladevorgangs und in einem gegebenen Variationsbereich der Stromstärke, der Spannung (U) und der entsprechenden Stromstärke (I), um daraus nach Verarbeitung einen Wert des Parameters (γ) der Batterie abzuleiten,

- Bestimmen des Ladezustands (SOC) der Batterie,

- und Bestimmen des für den Alterungszustand repräsentativen Wertes mit Hilfe der Parametrierung und des Wertepaares, das aus der gemessenen Temperatur und dem aus den Messungen abgeleiteten Parameter (γ) besteht, und für den Ladezustand (SOC), derart, daß eine Diagnose der Batterie erstellt wird.

2. Verfahren nach Anspruch 1, **dadurch gekennzeichnet, daß** die für den Alterungszustand repräsentativen Werte Werten der Kapazität der Batterie in Ah oder chemischen Kenndaten der Batterie entsprechen.

3. Verfahren nach Anspruch 1, **dadurch gekennzeichnet, daß** der Parameter (γ) der Batterie ausgehend von solchen Kenndaten der Batterie bestimmt wird, wie einem Spannungs- oder Stromstärkewert, der für einen Schwellwert der Stromstärke bzw. Spannung betrachtet wird, einem Verhältnis zwischen den Spitzenwerten der Spannung und der Stromstärke, einem Stromstärke- oder Spannungswert, der einem Spitzenwert der Spannung bzw. Stromstärke entspricht, oder der Änderung der Spannung und der Stromstärke in Abhängigkeit von der Zeit.

4. Verfahren nach einem der Ansprüche 1 bis 3, **dadurch gekennzeichnet, daß** es darin besteht, den Alterungszustand (SOH) der Batterie unter Berücksichtigung der Nennkapazität ($Q_n$) der Batterie zu bestimmen, welche ausgehend von den Strom-Spannungs-Kennlinien bestimmt wird, die für erhöhte Werte der Stromstärke aufgenommen wurden, während die Alterungsrate für Strom-Spannungs-Kennlinien berechnet wird, die für niedrige Werte der Stromstärke aufgenommen wurden.

5. Verfahren nach einem der Ansprüche 1 bis 4, **dadurch gekennzeichnet, daß** es darin besteht, die Nennkapazität der Batterie mit einem Empfehlungswert zu vergleichen, derart, daß ein Alarmsignal ausgegeben wird, wenn die Batterie eine Nennkapazität aufweist, die niedriger als der Empfehlungswert ist.

6. Verfahren nach Anspruch 1, **dadurch gekennzeichnet, daß** es darin besteht, ausgehend von den Messungen von Stromstärke und Spannung die Betriebsphasen der Batterie im Fahrzeug zu bestimmen, nämlich Laden, Ladungserhaltung, Entladen, Ruhe oder Anlassen.

7. Verfahren nach Anspruch 1, **dadurch gekennzeichnet, daß** es darin besteht, den Ladezustand (SOC) der Batterie ausgehend von Messungen der Kenndaten der Batterie, die während des Stillstands des Fahrzeugs durchgeführt werden, und von Matrizen, die den prozentualen Ladezustand (SOC) in Abhängigkeit von den Wertepaaren der Spannung (U) und der Temperatur (T) angeben, zu bestimmen.

8. Verfahren nach Anspruch 7, **dadurch gekennzeichnet, daß** es darin besteht, die Messungen nach einer Stillstandszeit des Fahrzeugs durchzuführen, die für die physikalisch-chemische Stabilisierung der Batterie erforderlich ist.

9. Verfahren nach Anspruch 1 oder 2, **dadurch gekennzeichnet, daß** es darin besteht, die Fähigkeit der Batterie zum Anlassen in Abhängigkeit von dem für den Alterungszustand repräsentativen Wert zu ermitteln.

10. Verfahren nach Anspruch 9, **dadurch gekennzeichnet, daß** es darin besteht, die Fähigkeit der Batterie zum Anlassen zu ermitteln, indem die Änderungen des für den Alterungszustand repräsentativen Wertes registriert werden, der bei der Wiederholung der Betriebsphase der Batterie bestimmt wird, und indem eine Information über die Fähigkeit der Batterie zum Anlassen geliefert wird, wenn der für den Alterungszustand repräsentative Wert einen bestimmten Schwellwert erreicht oder wenn die Änderung einen vorbestimmten Variationsbereich überschreitet.

11. Verfahren nach Anspruch 9, **dadurch gekennzeichnet, daß** es darin besteht, die Fähigkeit der Batterie zum An- lassen ($SOF_1$) zu ermitteln, indem ein Anlaß-Index (d) in Abhängigkeit vom Alterungszustand der Batterie für den Wert des Parameters (γ) und bei der gemessenen Temperatur (T) bestimmt wird.

12. Verfahren nach Anspruch 1, **dadurch gekennzeichnet, daß** es darin besteht:

- für den für den Alterungszustand repräsentativen Wert mit Hilfe der Parametrierung einen Wert des Parameters (γ) für den Wert der gemessenen Temperatur, der mit einem Sicherheitsfaktor versehen ist, und des bestimmten Ladezustands (SOC), der mit einem Sicherheitsfaktor versehen ist, abzuleiten,

- und vorausschauend die Fähigkeit der Batterie zum Anlassen ($SOF_2$) in Abhängigkeit vom Wert des Parameters (γ) der Batterie und von der Änderung der Betriebsbedingungen der Batterie zu ermitteln.

13. Verfahren nach Anspruch 11, **dadurch gekennzeichnet, daß** es darin besteht, den Anlaß-Index (d) während der Betriebsphase der Batterie mehrere Male zu berechnen und die Änderung dieses Index zu untersuchen, um eine Diagnose über die Fähigkeit der Batterie zum Anlassen zu liefern.

14. Verfahren nach Anspruch 13, **dadurch gekennzeichnet, daß** es darin besteht, in Abhängigkeit von dem Anlaß-Index eine Information zu liefern, daß das Anlassen problemlos ist, oder daß das Anlassen schwierig ist, oder daß das Anlassen unmöglich ist.

15. Verfahren nach Anspruch 14, **dadurch gekennzeichnet, daß** es darin besteht, für einen Anlaß-Index, der einem schwierigen Anlassen entspricht, eine Information mit der Empfehlung zu liefern, die Batterie zu erwärmen, zu laden oder auszutauschen.

16. Verfahren nach Anspruch 14 oder 15, **dadurch gekennzeichnet, daß** es darin besteht, für einen Anlaß-Index, der einem schwierigen Anlassen entspricht, zu empfehlen:

    - die Batterie zu laden, wenn der Ladezustand (SOC) niedrig ist,
    - die Batterie auszutauschen, wenn der Ladezustand (SOC) hoch ist.

FIG.1

FIG.2

SOH (0 à 100%)

SOH₁

V₁

SOC₁ 80%

SOC 60%

T°C (-30 à 60°C)

T₁

γ₁

γ (0 à 100%)

FIG.3

FIG.4

FIG.2A

FIG.5

FIG.6

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2003025481 A